Europäisches Patentamt

European Patent Office

Office européen des brevets

(19)

(11) EP 0 805 570 A1

## (12) DEMANDE DE BREVET EUROPEEN

(43) Date de publication:
05.11.1997 Bulletin 1997/45

(51) Int Cl.6: H04J 3/07, H03L 7/099

(21) Numéro de dépôt: 97400949.0

(22) Date de dépôt: 28.04.1997

(84) Etats contractants désignés:
DE ES FI GB IT SE

(30) Priorité: 02.05.1996 FR 9605496

(71) Demandeur: ALCATEL TELSPACE
92734 Nanterre Cédex (FR)

(72) Inventeurs:
• Pereira, Nathalie
95600 Eaubonne (FR)
• Debray, Bertrand
78600 Maisons Laffitte (FR)

(74) Mandataire: Scheer, Luc et al
ALCATEL ALSTHOM RECHERCHE,
Intellectual Property Department,
30, avenue Kléber
75116 Paris (FR)

(54) **Boucle à verrouillage de phase numérique pour récupération d'horloges**

(57) L'invention concerne une boucle à verrouillage de phase fournissant un signal d'horloge récupérée à partir d'un signal d'horloge de référence $F_{ref}$ dans lequel des transitions sont absentes. Elle comporte :

- un premier diviseur de fréquence par M recevant l'horloge $F_{ref}$ et fournissant un signal de fréquence $F_{ref}/M$ ;
- un comparateur de phase fournissant un signal d'erreur de phase à partir du signal de fréquence $F_{ref}/M$ et du signal de sortie d'un deuxième diviseur de fréquence par M ;
- un diviseur de fréquence par K fournissant un signal de fréquence $F_k$ à partir d'un signal d'oscillateur local de fréquence $F_{OL}$ recevant comme signal de commande le signal d'erreur de phase ;
- un additionneur-accumulateur de rapport de division p/q recevant le signal d'oscillateur local de fréquence $F_{OL}$ et fournissant un signal de fréquence $F_0$ égal à $F_{OL}*p/q$ ;
- un mélangeur fournissant un signal de fréquence $F_n$ égal à $F_0-F_k$ à partir du signal de fréquence $F_k$ et du signal de fréquence $F_0$ ;
- un diviseur de fréquence par N synchronisé par $F_{OL}$ recevant le signal de fréquence $F_n$ et fournissant l'horloge récupérée au deuxième diviseur de fréquence par M.

## Description

Le domaine de l'invention est celui des dispositifs de génération de signaux d'horloge et concerne plus particulièrement un dispositif destiné à récupérer un rythme d'horloge à partir d'une horloge de référence dans laquelle des transitions sont absentes. Le dispositif de l'invention doit notamment être apte à récupérer des horloges de fréquences différentes, c'est à dire présenter une fonctionnalité multi-débits.

On se placera dans la suite de cette description dans le cadre d'un système de transmission, par exemple par faisceaux hertziens, où les données numériques sont transmises dans des trames plésiochrones. Chaque trame véhicule une pluralité de communications et un récepteur de ces trames réalise un démultiplexage des données reçues afin de les appliquer sur différentes voies correspondant chacune à un destinataire différent. A chaque voie correspond une fréquence d'horloge.

En fait, les données de chaque voie, à la sortie du système de démultiplexage, sont synchronisées par une horloge à trous, c'est à dire dans laquelle des transitions sont absentes, pour leur écriture dans une mémoire tampon. Ces trous viennent de la justification lors du multiplexage émission, de l'absence des autres voies, et de l'insertion dans la trame de bits d'information (mot de verrouillage de trame, bits de parité, code correcteur d'erreur, etc.). Afin de permettre une relecture correcte des données reçues, il est nécessaire de régénérer une horloge exempte de trous, c'est à dire présentant des transitions régulières. On utilise pour cela habituellement une boucle à verrouillage de phase destinée à fournir une horloge régulière, de même fréquence que la fréquence moyenne de cette horloge à trous, pour lire les données stockées temporairement dans la mémoire tampon.

On considérera dans la suite de cette description trois débits de transmission différents (1,544 Mbits/s, 2,048 Mbits/s et 8,448 Mbits/s), et donc 3 fréquences d'horloge à récupérer différentes. Les précisions des horloges à récupérer sont, dans le système considéré, de ±50 ppm pour les débits de 1,544 Mbits/s et 2,048 Mbits/s et de ±30 ppm pour le débit de 8,448 Mbits/s.

L'invention propose une solution numérique plutôt qu'analogique pour la réalisation de la fonction de récupération d'horloge pour des raisons de modularité, de réutilisabilité (composants reprogrammables), d'intégration et de coût (implantable dans des circuits ASICs).

La présente invention vise notamment à respecter les recommandations du CCITT suivantes : G823 (ou G824 pour les débits américains) concernant la gigue maximale admissible à une interface hiérarchique, G921 concernant la gigue résiduelle, G703 sur les précisions des horloges et les gabarits des impulsions, G751 pour le multiplexage/démultiplexage aux débits tramés de 34,368 Mbits/s (soit 4*8,448 Mbits/s) avec justification positive pour le transfert de gigue, G742 pour le multiplexage/démultiplexage au débit 2,048 Mbits/s avec justification positive pour le transfert de gigue et G743 pour le multiplexage/démultiplexage du débit d'affluent de 1,544 Mbits/s pour le transfert de gigue.

On connaît, par la demande de brevet européen n°0.471.506, un dispositif numérique apte à régénérer un signal d'horloge régulier à partir d'une horloge trouée. Cependant, ce dispositif ne fonctionne que si l'horloge à récupérer est une horloge synchrone du signal transmis et suppose que l'horloge à régénérer est une fraction rationnelle de l'horloge trouée. Ce dispositif ne convient donc pas pour un système de transmission plésiochrone où les différents affluents ont chacun leur propre horloge.

La présente invention a notamment pour objectif de pallier cet inconvénient.

Plus précisément, la présente invention a pour objectif de fournir un dispositif destiné à fournir une horloge régulière, appelée horloge récupérée, dont la fréquence est égale à la fréquence moyenne de l'horloge à trous (horloge de référence) dans un système plésiochrone.

Cet objectif, ainsi que d'autres qui apparaîtront par la suite, est atteint grâce à une boucle à verrouillage de phase numérique du type fournissant un signal d'horloge, appelé horloge récupérée, à partir d'un signal d'horloge de référence dans lequel des transitions sont absentes, appelé horloge trouée et de fréquence $F_{ref}$, cette boucle comportant :

- un premier diviseur de fréquence par M recevant l'horloge trouée et fournissant un signal de fréquence $F_{ref}/M$ ;
- un comparateur de phase à deux entrées, l'une des entrées recevant le signal de fréquence $F_{ref}/M$, l'autre des entrées recevant le signal de sortie d'un deuxième diviseur de fréquence par M, le comparateur de phase fournissant un signal d'erreur de phase ;
- un diviseur de fréquence par K d'un signal d'oscillateur local de fréquence $F_{OL}$ recevant comme signal de commande le signal d'erreur de phase et fournissant un signal de fréquence $F_k$ ;
- un additionneur-accumulateur recevant le signal d'oscillateur local de fréquence $F_{OL}$ et fournissant un signal de sortie de fréquence $F_0$ égal à $F_{OL}*p/q$ avec p/q le rapport de division de l'additionneur-accumulateur ;
- un mélangeur recevant le signal de fréquence $F_k$ et le signal de fréquence $F_0$, le mélangeur fournissant un signal de fréquence $F_n$ égal à $F_0-F_k$ ;
- un diviseur de fréquence par N synchronisé par $F_{OL}$ recevant le signal de fréquence $F_n$ et fournissant l'horloge récupérée au deuxième diviseur de fréquence par M.

Avantageusement, un diviseur de fréquence par T est inséré entre le mélangeur et le diviseur de fréquence par N. Le comparateur de phase est préférentiellement constitué par une porte Ou-Exclusif.

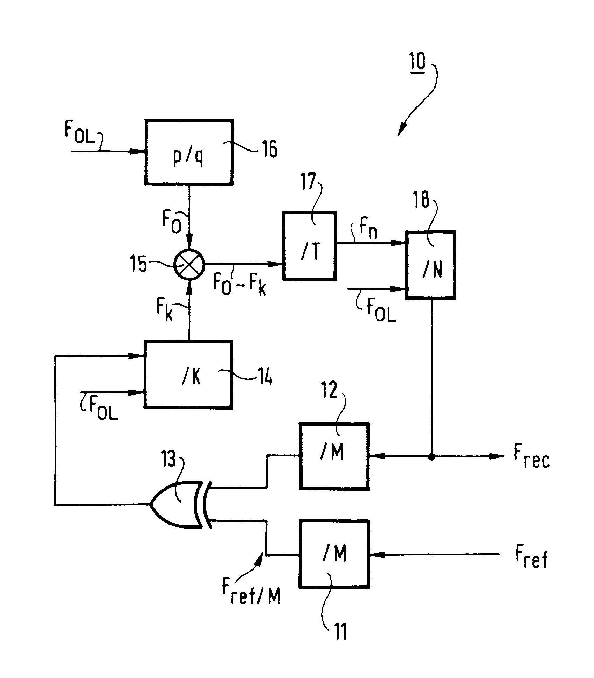

D'autres caractéristiques et avantages de l'invention apparaîtront à la lecture de la description suivante d'un mode de réalisation préférentiel, donné à titre illustratif et non limitatif, et de la figure unique annexée représentant un schéma synoptique de la boucle à verrouillage de phase selon l'invention.

La boucle à verrouillage de phase selon l'invention, généralement référencée par 10, reçoit un signal d'horloge de référence de fréquence $F_{ref}$ dans lequel des transitions sont absentes. Cette horloge peut être qualifiée d'horloge trouée. La boucle 10 fournit un signal d'horloge $F_{rec}$, appelé horloge récupérée, à partir de l'horloge de référence $F_{ref}$ et d'un signal d'oscillateur local de fréquence $F_{OL}$. La fréquence $F_{OL}$ est par exemple au moins 8 fois supérieure à la fréquence de l'horloge récupérée $F_{rec}$, afin de respecter la norme G823 à 8 Mbits/s. La valeur du rapport $F_{OL}/F_{rec}$ dépend en fait essentiellement des performances voulues pour la gigue mesurée sur l'horloge récupérée. La taille de la mémoire tampon (constituée par exemple par une FIFO) dépend essentiellement de la gigue sur l'horloge de référence causée par les trous du démultiplexage et donc essentiellement de la structure de trame utilisée.

L'horloge trouée de fréquence $F_{ref}$ est appliquée à un premier diviseur de fréquence par M, référencé 11 et fournissant un signal de fréquence $F_{ref}/M$. De même, l'horloge récupérée de fréquence $F_{rec}$ et issue d'un diviseur par N référencé 18, est appliquée à un deuxième diviseur de fréquence par M, référencé 12 et fournissant un signal de fréquence $F_{rec}/M$. Les signaux de fréquence $F_{ref}/M$ et $F_{rec}/M$ sont appliqués à un comparateur de phase 13 à deux entrées, constitué ici par une porte Ou-Exclusif ou par une bascule D dans un autre mode de réalisation. On ne considérera dans la suite de cette description que la réalisation du comparateur de phase sous la forme d'une porte Ou-Exclusif.

La comparaison de phase est donc réalisée entre l'horloge de référence et l'horloge récupérée divisées par M. Cette division permet de réduire la gigue à l'entrée de la boucle, qui est causée par les trous de l'horloge de référence : la gigue haute fréquence est filtrée et la taille des trous par rapport à la période de comparaison est diminuée. Il est en effet important, pour que la boucle reste verrouillée, de limiter l'erreur de phase à la plage de synchronisation du comparateur de phase et de rester dans son mode de fonctionnement linéaire. Dans ce cas, la gigue maximale du signal de comparaison est de 1 IU crête-à-crête, IU étant la durée nominale qui sépare deux instants significatifs consécutifs d'un signal isochrone. La gigue maximale de l'horloge de référence divisée par M est de 0,5 IU avec le Ou-Exclusif comme comparateur de phase.

Il est avantageux d'utiliser un comparateur de phase constitué par un Ou-Exclusif car ce type de comparateur est adapté aux signaux ayant un rapport cyclique de 1/2 (cas des signaux d'horloge divisés par M), il présente un gain $K_d$ égal à $1/\pi$ et sa réalisation sous la forme d'un ASIC est simple.

Pour lire la mémoire tampon, on utilise tous les bits à droite du bit de poids le plus fort si le comparateur de phase est un Ou-Exclusif : ainsi les poids forts des adresses d'écriture et de lecture sont en opposition de phase. La taille de la mémoire tampon est donc liée à M car, lorsque la boucle est accrochée, la sortie du comparateur de phase a un rapport cyclique de 1/2.

Le signal d'erreur de phase issu du comparateur 13 constitue un signal de commande appliqué à un diviseur de fréquence par K, référencé 14. La valeur moyenne du signal de sortie du comparateur de phase est proportionnelle à l'erreur de phase. Le diviseur de fréquence 14 reçoit en outre un signal d'oscillateur local de fréquence $F_{OL}$ et fournit un signal de fréquence $F_k$.

La fréquence $F_k$ est comprise entre 0 Hz et $F_{OL}/K$. Ainsi, lorsque la boucle est verrouillée à la fréquence centrale $f_c$ (de fréquence égale au débit de l'horloge à récupérer), le signal de commande du compteur K contient autant de 1 que 0, et donc $F_k = F_{OL}/2K$. La fréquence récupérée minimale correspond alors à $F_k = F_{kmin} = 0$ Hz, et la fréquence maximale à $F_k = F_{kmax} = F_{OL}/K$. Pour que la boucle reste accrochée, il faut que la fréquence $F_k$ nécessaire pour recaler $F_{rec}$ sur $F_{ref}$ soit comprise entre $F_{kmin}$ et $F_{kmax}$ et que la gigue de $F_K$ causée par les trous de l'horloge de référence ne fassent pas sortir $F_k$ de ces limites.

La plage d'accrochage de la boucle est d'autant plus grande que la valeur de K est petite. En revanche, le réglage de $F_{rec}$ est d'autant plus fin que la valeur de K est grande. Il y a donc un compromis à trouver. En pratique, il faudra vérifier que la plage d'accrochage est nettement supérieure à ±30 ppm ou ±50 ppm selon le débit, en tenant compte de la précision de $F_{OL}$. De plus, il faudra qu'à des valeurs limites, les proportions d'états logiques 0 et 1 du signal de commande soient le plus proche possible de 50 %, afin de disposer d'un rapport cyclique de 1/2. Ainsi la largeur admise des trous de l'horloge de référence $F_{ref}$ sera d'autant plus grande.

Le signal de fréquence $F_k$ issu du diviseur 14 est appliqué à un mélangeur 15 recevant par ailleurs un signal de fréquence fixe $F_0$ d'un additionneur-accumulateur 16 à l'entrée duquel est appliqué le signal de fréquence $F_{OL}$. Le mélangeur 15 fournit un signal de sortie de fréquence $F_0-F_k$.

L'additionneur-accumulateur 16 fournit le signal de fréquence $F_0$ égal à $F_{OL}*p/q$ avec $p/q$ le rapport de division de l'additionneur-accumulateur 16.

Le signal de fréquence $F_0-F_k$ issu du mélangeur 15 est appliqué éventuellement à un diviseur de fréquence par T, référencé 17, facultatif et dont la fonction sera explicitée par la suite.

Le signal issu du mélangeur 15 (ou celui issu du diviseur par T référencé 17) est appliqué à un diviseur de fréquence par N, référencé 18. Le signal d'entrée de ce diviseur 18 est noté $F_n$ et correspond soit à $F_0$-$F_k$, soit à $(F_0$-$F_k)/T$. Le diviseur 18 est synchronisé par $F_{OL}$ et fournit l'horloge récupérée de fréquence $F_{rec}$ au deuxième diviseur de fréquence par M, référencé 12.

Le diviseur 18 par N est synchronisé par $F_{OL}$ (c'est à dire que le comptage est réalisé par $F_{OL}$ et interrompu à la fréquence $F_n$).

Le diviseur par T référencé 17 fonctionne avec T = 2 ou T = 4. Ce diviseur a été introduit pour diminuer l'amplitude de gigue résiduelle.

Les variations de $F_0$ peuvent être réduites en choisissant une valeur de p petite. De plus, les variations les plus importantes de $F_n$ sont causées par les interruptions à la fréquence $F_k$ ; à la fréquence moyenne $F_k$, on supprime un front d'horloge de $F_0$, la période est alors doublée instantanément. Le diviseur par T divise par T l'amplitude de cette gigue.

L'étude théorique de la boucle selon l'invention est réalisée ci-après :

Comme indiqué précédemment, la valeur moyenne du signal de sortie du comparateur de phase 13, notée $\overline{Ud}$, est proportionnelle à l'erreur de phase :

$$\overline{Ud} = K_d * \Phi_e$$

La fréquence du signal de sortie du diviseur 14 s'écrit donc :

$$F_k = \overline{Ud} * \frac{F_{OL}}{K}$$

Et on a également :

$$F_0 = F_{OL} * \frac{p}{q}$$

et

$$F_n = \frac{1}{T}(F_0 - F_k)$$

La fréquence récupérée s'écrit donc :

$$F_{rec} = \frac{1}{N}[F_{OL} - \frac{1}{T}(F_{OL} * \frac{p}{q} - F_k]$$

En entrée du comparateur de phase, on a $f_1 = F_{ref}/M$ et $f_2 = F_{rec}/M$. $\Phi_e = f_1$-$f_2$. D'où :

$$\frac{d\Phi_{rec}}{dt} = 2\pi * F_{rec} = \frac{2\pi}{N}\left[F_{OL} - \frac{1}{T}\left(F_{OL} * \frac{p}{q} - \frac{F_{OL} * K_d * (\Phi_{ref} - \Phi_{rec})}{K * M}\right)\right]$$

Le passage dans le plan complexe donne :

$$j\omega\Phi_{rec} = K_{tot} * (\Phi_{rec} - \Phi_{ref}) \text{ avec } K_{tot} = \frac{2\pi * F_{OL} * Kd}{T * N * K * M}$$

D'où :

$$G(j\omega)= \frac{\Phi_{rec}\ (j\omega)}{\Phi_{ref}\ (j\omega)} = \frac{K_{tot}}{j\omega + K(j\omega)}$$

La fréquence de coupure du système est donc égale à :

$$F_{3db} = \frac{K_{tot}}{2\pi} = \frac{F_{OL} * Kd}{T * N * K * M} = \frac{F_{OL}}{\pi.T.N.K.M}$$

La plage d'accrochage de la boucle s'écrit :

$$F_{rec} = \frac{1}{N}\left[ F_{OL} - \frac{1}{T}\left( F_{OL} * \frac{P}{q} - \frac{F_{OL} * K_d * \left(\Phi_{ref} - \Phi_{ref}\right)}{K * M} \right) \right]$$

$$\text{Avec } 0 \leq \overline{u}_d = \frac{Kd * (\Phi_{rec} - \Phi_{ref})}{M} \leq 1$$

D'où:

$$F_{rec\_max} = \frac{F_{ol}}{N} . [1 - \frac{p}{q.T} + \frac{1}{T.K} ]$$

et

$$F_{rec\_min} = \frac{F_{ol}}{N} . [1 - \frac{p}{q.T} ]$$

La plage d'accrochage théorique est définie par :

$$\Delta F\_max = F_{rec\_max} - F_{rec\_min} = \frac{F_{OL}}{N.T.K}$$

La fréquence centrale de la boucle est :

$$F_c = \frac{F_{OL}}{N} . [1 - \frac{p}{q.T} + \frac{1}{2T.K} ] \hspace{3cm} (1)$$

avec $F_c$ pouvant varier entre

$$F_c - \frac{\Delta F\_max}{2}$$

et

$$F_c + \frac{\Delta F\_max}{2}$$

La plage d'accrochage théorique de la boucle est indépendante du type de comparateur, tant que l'erreur de phase en entrée est dans sa plage de synchronisation. Lorsque l'horloge de référence est entachée de trous, la plage d'accrochage réelle est plus petite ; la boucle se déverrouille lorsque la fréquence de référence sort de la plage d'accrochage ou lorsqu'elle subit des variations trop rapides vis-à-vis du temps de réponse du système.

Afin d'augmenter la plage d'accrochage en présence de trous, on peut augmenter le rang du diviseur par M. On réduit ainsi la gigue du signal de comparaison de phase, on diminue la fréquence de coupure de la boucle et on augmente son temps de réponse. Le système filtre alors mieux la gigue de l'horloge de référence, mais le temps d'accrochage est plus long. On a donc intérêt à choisir M le plus petit possible, d'autant plus que la taille de la mémoire tampon est liée à M.

Lorsque la fréquence de référence $F_{ref}$ est différente de sa valeur nominale, le signal de comparaison à l'équilibre a des proportions de 1 et de 0 différentes. Le système admet alors moins de gigue sur l'horloge de référence : si par exemple, la position d'équilibre correspond à 60% d'états logiques 1 et à 40% d'états logiques 0, la gigue maximale du signal de comparaison devient alors 2*0,4 = 0,8 IU crête-à-crête, au lieu de 1 IU. Plus la plage d'accrochage est grande, plus les proportions d'états logiques 1 et 0 aux valeurs limites de $F_{ref}$ seront proches, et plus la gigue admise sur le signal de comparaison de phase sera proche de 1 IU.

Le choix de la valeur de M dépend donc de la structure de trame et du temps de réponse du système, c'est-à-dire de sa fonction de transfert. Il y a compromis à trouver, car le temps de réponse du système augmente avec M, créant un équilibre moins stable, tandis que sa fréquence de coupure diminue, permettant un meilleur filtrage des perturbations sur l'horloge de référence. Si on augmente la largeur des trous de l'horloge de référence, il faut augmenter la plage d'accrochage de la boucle, et éventuellement la valeur de M et la taille de la mémoire tampon.

La gigue de l'horloge récupérée provient essentiellement des variations du rang de division du compteur N. On peut la quantifier en étudiant les variations de la fréquence d'interruption du compteur : $F_n$

$$F_{n\_MIN} \leq F_n \leq F_{n\_MAX}$$

La valeur de N est choisie de la manière suivante :

$$F_{ol}/N \geq F_c > F_{ol}/(N+1)$$

On a donc $F_n = F_{ol} - N*F_c < F_c$ et le compteur N est interrompu soit 0 soit 1 fois par période de l'horloge récupérée. Les valeurs extrêmes de $F_n$ sont :

$$F_{n\_MIN} = 0$$

$$F_{n\_MAX} = F_c$$

La période de l'horloge récupérée est donc constitué de N ou N+1 périodes de $F_{ol}$. L'amplitude de la gigue résiduelle observée sur l'horloge récupérée est donc de l'ordre d'une période de $F_{ol}$, soit environ 1/N IU crête-à-crête.

Le pas de sortie est la valeur minimale de variation de la fréquence lorsque le rang de division du compteur K change d'une unité. Ce pas de sortie est noté P et vaut :

$$P = \frac{F_{OL}}{T.N.K.\,(K+1)}$$

On remarque que K doit être assez grand pour un pas de sortie raisonnable (quelques Hz). On préférera aussi une grande valeur de N.

On note $\tau$ le pourcentage de niveaux logiques '1' du signal issu du comparateur de phase 13. La valeur de $\tau$ est :

$$\tau = K.T.\left[\frac{N.F_C}{F_{OL}} - 1 + \frac{p}{q.T}\right]$$

La valeur minimale de $\tau$ (notée $\tau_{min}$) est obtenue pour $F_{OL\_max}$ et $\tau_{max}$ vaut $1 - \tau_{min}$.

La boucle décrite jusqu'ici est applicable non seulement aux trois débits mentionnés mais également à d'autres débits, notamment lorsque la gigue de l'horloge récupérée est importante.

Plus précisément, la fréquence centrale de la boucle est entièrement programmable grâce :

- au choix de N qui permet d'approcher $F_c$ selon la relation

$$F_{ol}/(N+1) \leq F_c \leq F_{ol}/N$$

- au choix de l'additionneur-accumulateur (et de T) qui permet d'approcher plus finement la fréquence $F_c$. La fréquence $F_c$ est légèrement supérieure à :

$$\frac{F_{OL}}{N} \left(1 - \frac{p}{q.T}\right)$$

- la contribution de $F_k$ plus ou moins grande selon l'erreur de phase, de valeur faible par rapport à l'horloge récupérée (de l'ordre de 50-100 kHz). Plus la fréquence $F_k$ est importante (K petit), plus la boucle d'accrochage de la boucle est importante. En revanche, l'horloge récupérée est plus sensible aux variations de l'erreur de phase : la fréquence de coupure de la boucle est d'autant plus grande que K est petit.

Les valeurs des paramètres dépendent d'abord du rapport $F_{OL}/F_{rec}$ : ce rapport fournit, à partir de la relation 1, une valeur entière de N à partir de laquelle est déterminé la plus petite valeur de $F_n$ possible. A partir de $F_n$, on détermine ensuite les valeurs de K, T et p/q en notant que plus la fréquence $F_k$ est importante, plus la plage d'accrochage est grande mais aussi plus la gigue est importante.

Une application numérique de l'invention est donnée dans le tableau en annexe. On considère les trois débits de transmission précités (1,544 Mbits/s, 2,048 Mbits/s et 8,448 Mbits/s), et donc 3 fréquences d'horloge à récupérer différentes pour les choix de M, K, p, q, N et éventuellement T, avec un comparateur de phase constitué par un Ou-Exclusif. La valeur de $F_{OL}$ est de 68,736 MHz.

Dans le tableau, la profondeur de la mémoire tampon est de 16 bits (M=32) pour les débits de 1,544 Mhz et 2,048 Mhz et de 32 bits (M=64) pour le débit de 8,448 Mhz. La profondeur de l'additionneur-accumulateur est de 11 bits. Le choix de M dépend de la structure de trame, comme cela a été décrit précédemment.

Dans le cadre d'une application spécifique, le trou le plus grand de l'horloge de référence est causé par un mot de verrouillage de trame de 12 bits, le débit tramé est de 9,874 Mhz et la fréquence de l'horloge à récupérer est de 8,448 Mhz. Dans ce cas, la gigue maximale de l'horloge trouée est de $(12/9,874) * 8,448 \approx 10$ IU crête-à-crête rapportés à la fréquence de l'horloge récupérée à 8,448 Mhz. La gigue causée par ce trou sur le signal de comparaison de phase est d'environ 10/M, soit environ 0,31 IU pour M = 32 et 0,16 IU pour M = 64. Il faut donc prendre $\tau_{min} > 0,31$ pour M = 32 et $\tau_{min} > 0,16$ pour M = 64.

Des essais ont permis de vérifier le bon fonctionnement de la boucle selon l'invention lorsque la fréquence de référence varie de ±30 ppm autour de sa valeur nominale, pour le débit 8,448 Mbits/s, et de ±50ppm pour les autres débits. La boucle reste accrochée à ces fréquences. Elle fonctionne aussi avec une précision de l'oscillateur local de ±50 ppm. La plage d'accrochage mesurée est inférieure à la plage théorique, en raison des trous de l'horloge de référence.

La boucle à verrouillage de phase de l'invention est notamment implantable en ASIC.

## ANNEXE

|  | Fc = 1,544 MHz | Fc = 2,048 MHz | Fc = 8,448 MHz |
|---|---|---|---|
| M | 32 | 32 | 64 |
| K | 771 | 757 | 601 |
| p | 49 | 70 | 139 |
| q | 2048 | 2048 | 2048 |
| T | 2 | 2 | 4 |
| N | 44 | 33 | 8 |
| Fo (MHz) | 1,645 | 2,349 | 4,666 |
| Fk (kHz) | 45,5 | 45,4 | 57,2 |
| Fn (MHz) | 0,8 | 1,152 | 1,152 |
| F3dB (Hz) | 10,1 | 13,7 | 17,8 |
| Frec_min (MHz) | 1,543 | 2,047 | 8,446 |
| Frec_max (MHz) | 1,545 | 2,049 | 8,449 |
| P (Hz) | 1,3 | 1,8 | 5,9 |
| $\tau_{min}$ | 0,5 | 0,5 | 0,5 |

## Revendications

1. Boucle à verrouillage de phase numérique, du type fournissant un signal d'horloge, appelé horloge récupérée ($F_{rec}$), à partir d'un signal d'horloge de référence dans lequel des transitions sont absentes, appelé horloge trouée et de fréquence $F_{ref}$, caractérisée en ce qu'elle comporte :

   - un premier diviseur de fréquence (11) par M recevant ladite horloge trouée (Fref) et fournissant un signal de fréquence $F_{ref}/M$ ;
   - un comparateur de phase (13) à deux entrées, l'une desdites entrées recevant ledit signal de fréquence $F_{ref}/M$, l'autre desdites entrées recevant le signal de sortie d'un deuxième diviseur de fréquence (12) par M, ledit comparateur de phase (13) fournissant un signal d'erreur de phase ;
   - un diviseur de fréquence (14) par K d'un signal d'oscillateur local de fréquence $F_{OL}$ recevant comme signal de commande ledit signal d'erreur de phase et fournissant un signal de fréquence $F_k$ ;
   - un additionneur-accumulateur (16) recevant ledit signal d'oscillateur local de fréquence $F_{OL}$ et fournissant un signal de sortie de fréquence $F_0$ égal à $F_{OL}*p/q$ avec p/q le rapport de division dudit additionneur-accumulateur (16) ;
   - un mélangeur (15) recevant ledit signal de fréquence $F_k$ et ledit signal de fréquence $F_0$, ledit mélangeur (15) fournissant un signal de fréquence $F_n$ égal à $F_0-F_k$ ;
   - un diviseur de fréquence (18) par N synchronisé par $F_{OL}$ recevant ledit signal de fréquence $F_n$ et fournissant ladite horloge récupérée (Frec) audit deuxième diviseur de fréquence (12) par M.

2. Boucle à verrouillage de phase selon la revendication 1, caractérisée en ce qu'elle comporte en outre un diviseur de fréquence (17) par T inséré entre ledit mélangeur (15) et ledit diviseur de fréquence (18) par N.

3. Boucle à verrouillage de phase selon l'une des revendications 1 et 2, caractérisée en ce que ledit comparateur de phase est constitué par une porte Ou-Exclusif (13).

**Office européen des brevets**

## RAPPORT DE RECHERCHE EUROPEENNE

Numero de la demande

EP 97 40 0949

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | ELECTRONICS & COMMUNICATIONS IN JAPAN, PART I - COMMUNICATIONS, vol. 75, no. 4, 1 avril 1992, pages 1-12, XP000307927 YOSHINORI ROKUGO ET AL: "A DIGITAL PHASE-LOCKED LOOP FOR STUFFING SYNCHRONIZATION SYSTEMS" * page 2, colonne de gauche, alinéa 2 - colonne de droite, alinéa 2 * * page 5, colonne de droite, alinéa 3.2 - page 7, colonne de droite, alinéa 3.3 * --- | 1,3 | H04J3/07 H03L7/099 |
| A | US 4 803 680 A (ROKUGO YOSHINORI ET AL) 7 février 1989 * colonne 3, ligne 18 - ligne 47 * * colonne 4, ligne 43 - colonne 5, ligne 12 * * colonne 7, ligne 57 - colonne 8, ligne 26 * * colonne 8, ligne 62 - colonne 9, ligne 2 * * colonne 9, ligne 26 - ligne 47 * * figures 2,6 * --- | 1 | |
| A | DE 20 23 656 A (FERNMELDETECHNISCHES ZENTRALAM;DEUTSCHE BUNDESPOST) 2 décembre 1971 * page 4, alinéa 4 - page 6, alinéa 1; figure 1 * --- | 1 | **DOMAINES TECHNIQUES RECHERCHES (Int.Cl.6)** H04J H03L H04L |
| A | AU 604 997 B (STC) 3 janvier 1991 * page 6, ligne 10 - page 7, ligne 20; figures 2,4 * ----- | 1 | |

Le présent rapport a été établi pour toutes les revendications

| Lieu de la recherche | Date d'achèvement de la recherche | Examinateur |
|---|---|---|
| LA HAYE | 5 août 1997 | Pieper, T |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)